(19) Europäisches Patentamt
European Patent Office
Office européen des brevets

(11) Publication number : **0 358 517 B1**

# (12) EUROPEAN PATENT SPECIFICATION

(45) Date of publication of patent specification : **22.11.95 Bulletin 95/47**

(51) Int. Cl.$^6$ : **G03F 7/075**

(21) Application number : **89309109.0**

(22) Date of filing : **08.09.89**

## (54) Compositions including a phenolic resin and a sensitizer.

(30) Priority : **08.09.88 US 241657**

(43) Date of publication of application : **14.03.90 Bulletin 90/11**

(45) Publication of the grant of the patent : **22.11.95 Bulletin 95/47**

(84) Designated Contracting States : **AT BE CH DE FR GB IT LI**

(56) References cited : **US-A- 4 690 882**

(73) Proprietor : **ENZYMOL INTERNATIONAL, INC.**
**115 South Columbia Avenue**
**Bexley, Ohio 43209 (US)**

(72) Inventor : **Liang, Rong-Chang**
**386 Lightbeam Drive**
**Centerville Ohio 45458 (US)**
Inventor : **Pokora, Alexander R.**
**12931 Oakmere Drive**
**Pickerington Ohio 43147 (US)**
Inventor : **Cyrus, William L.**
**RFD No.1, Box 284**
**Ray Ohio 45672 (US)**

(74) Representative : **Deans, Michael John Percy et al**
**Lloyd Wise, Tregear & CO.**
**Norman House**
**105-109 Strand**
**London WC2R OAE (GB)**

EP 0 358 517 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Jouve, 18, rue Saint-Denis, 75001 PARIS

## Description

The present invention relates to a composition including phenolic resin and a sensitizer, and to the use of such compositions.

Photoresist compositions are facing new challenges in the fabrication of microelectronic components. The need to mass-produce submicron circuits has resulted in a demand for resists with the properties of high resolution, high thermal resistance, high plasma resistance and optimal dissolution characteristics.

When producing a microelectronic component such as a microchip, the amount of information which can be placed on the chip is a direct function of the resolution available with the photoresist. As the resolution of the photoresist increases, higher storage capacities are attainable in the microelectronic component. Accordingly, there is an ongoing effort in the industry to produce photoresists which are capable of higher resolution.

Positive-working photoresist materials evolved from discoveries made by the Kalle Corporation which developed the first positive-acting photoresist based on the use of a novolak matrix resin and a diazoquinone photo-active compound or sensitizer which retards dissolution of the novolak. To produce the Kalle photoresist, the sensitizer and novolak resin are dissolved in an organic solvent and the resultant solution is coated onto a substrate such as a silicon wafer using methods known in the art such as spin coating. The coating solvent is then removed from the resist composition to produce a film on the substrate in which the sensitizer is uniformly distributed throughout the novolak matrix. Upon exposure of the photoresist composition to radiation, the sensitizer is converted into a base-soluble, acidic photoproduct that does not retard dissolution of the novolak in the exposed regions. After exposure, the photoresist is selectively dissolved in an aqueous base to remove the areas of the photoresist which were subject to the image-wise exposure. Images produced from positive-working resists are extremely accurate, require minimal processing techniques and involve few processing steps. Examples of such positive-working photoresist compositions are disclosed in UK Patent No. 784,672; U.S. Patent No. 3,402,044; U.S. Patent No. 4,365,019 and U.S. Patent No. 4,684,599. The resins most often used with positive-resist sensitizers are the phenol formaldehyde novolak and its derivatives and poly(p-vinylphenols).

Positive-working photoresist compositions as described above are used in the semiconductor chip industry. After removing the exposed portions of the resist pattern, the underlying substrate is etched. Dry etching or plasma etching techniques are now commonly used to achieve the submicron resolution that is required to produce microchips having storage capacity which approaches and exceeds one megabyte. Resins having sufficiently high thermal stability and plasma resistance to be used with these high resolution techniques are therefore required.

Two plasma etching or resist removal techniques have been used in the microchip industry. In the single layer resist technique, a single layer of a photoresist is applied to the surface of a silicon chip the resist is exposed and then developed with an alkaline solution to remove the exposed portions of the resist. The substrate is then plasma etched using a $CF_4$ plasma. The areas of the substrate which are not protected by the resist are removed. In a second process, known as the multilayer resist process, a photoresist containing silicon is coated over a layer of a second resist material on a substrate. The second resist may be photosensitive or non-photosensitive. The silicon-containing resist is exposed and developed with an alkaline developer solution to uncover areas of the underlying resist. The multilayer resist is then subjected to an oxygen plasma which converts the silicon present in the upper resist to silicon dioxide and removes the uncovered areas of the underlying resist.

Attempts have been made to improve the thermal stability and plasma resistance of novolak resists. Following development resists have been heated to above their cross-linking temperature to produce a thermally stable structure. However, the cross-linking temperature of novolak resists is much higher than the glass transition temperature of the resists, creating a thermally stable resist profile only after severe reflow.

Other well-known hardening techniques consist of cross-linking the novolak resin resist by irradiation with deep UV light or by subjecting the image resist to a non-eroding plasma. These techniques harden the resist image only at the surface because of limited penetration of the cross-linking action. Surface hardening works well with small features. With larger features, the skin is not sufficiently rigid to hold the bulk of the resist which deforms at temperatures above the glass transition temperature. Hardening by electron beam or ion beam bombardment can crosslink the resist in the bulk but there is a possibility of radiation damage of the semiconductor devices on the wafer as well as high equipment costs.

Further refinements include progressive heating of the resist image while it undergoes skin hardening, but extremely sophisticated microprocessor control must be implemented and the process must be reoptimized frequently.

It is also known in the art to overcoat the novolak resin with polymethyl methacrylate. Although this improves resolution, the production of the resist involves increased production steps and increased cost. Moreover, the overcoating introduces an additional possibility of error into the photoresist composition.

Accordingly, there exists a need in the art for a simple positive-working photoresist composition which is capable of submicron resolution and can be produced in a minimum number of steps.

In accordance with a first aspect of the present invention, we provide a composition comprising a phenolic resin and a sensitizer, said sensitizer being effective when exposed to actinic radiation, to render said composition alkaline soluble, said phenolic resin being represented by the formula (I) or (II):

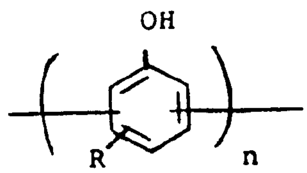

(I)

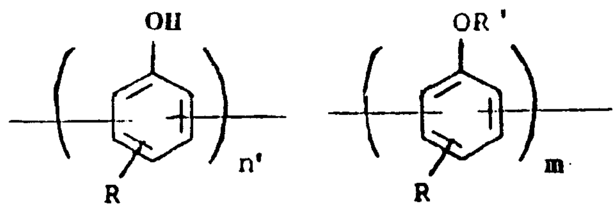

(II)

wherein R is a hydrogen atom, a halogen atom, an alkyl group, an alkoxy group, an alkaryl group, an aryl group or a silyl group, and may be the same or different within the polymer; R′ is a silyl group; and n and n′+m are greater than 2.

By comparison to prior art photoresist compositions containing a phenol-formaldehyde novolak resin, the present compositions when used as photoresists are able to provide higher resolution. The improved resolution is accomplished as a result of the photoresist composition having improved thermal and plasma resistance and improved dissolution characteristics in basic developers.

The polymer represented by formulas (I) and (II) is preferably a simple statistical copolymer.

The photoresist composition is believed to be superior to prior photoresists based on novolak resins because of the absence of the methylene linkage in the phenolic resin. As a result, the photoresist composition has a high thermal and plasma resistance and improved dissolution characteristics as compared to resists prepared from novolak resins. Polyphenols in accordance with formula (I) in which at least a portion of the R substituents are silyl groups and polyphenols in accordance with formula (II) in which m is greater than 0 are particularly useful in a multilayer resist process.

Preferably, the resin is further characterised in that it is prepared by reacting a phenol with a peroxidase enzyme in the presence of a peroxide or an oxidase enzyme in the presence of oxygen in an organic solvent containing medium. Compositions employing polyphenols produced by the above enzymatic process are advantageous over prior art photoresist compositions containing novolak resins for an additional reason. Novolak resins are generally prepared using a metal catalyst (although sulphuric acid is also used it does not provide good control over molecular weight). To use these novolak resins as part of a photoresist composition, it is necessary that the catalytic amount of metal ions be removed from the resin. This is particularly so in the case where the photoresist composition is coated on to a silicon wafer for use in making a silicon chip. While the enzymes used in preparing the resins used in the present compositions contain a metal such as iron, they are readily removed by extracting a solution of the resin in a solvent with water. This results in an increase in efficiency and reduces the costs of materials used to produce metal-free photoresists.

In another aspect of the present invention, there is provided a material useful in manufacturing a microelectronic component comprising a substrate having a coating of the composition defined above on one surface.

The present invention also provides a process for forming a resist image which comprises applying a composition as defined above to a substrate, and image-wise exposing the composition to actinic radiation.

Another manifestation of the present invention is polyphenols of the formula (I) or (II) which are single-substituted as described herein.

While the compositions of the present invention are particularly useful in the preparation of microelectronic components, those skilled in the art will recognize that they are equally useful in other applications in which resists containing novolak resins have previously been used such as in making printing plates, printed circuits,

etc..

The invention is hereinafter more particularly described by way of example only.

The composition comprises a phenolic resin and a sensitizer. The composition is preferably used as a photoresist composition and is capable of becoming alkaline soluble upon exposure to actinic radiation. The polymer resin portion of the composition is more preferably a phenolic resin as is set forth in either Formula IA or Formula IIA:

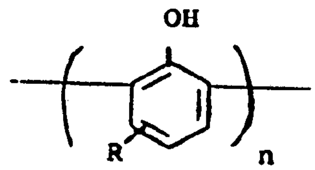

(IA)

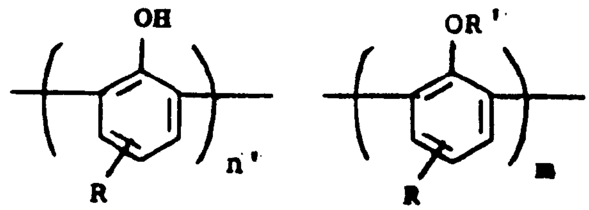

(IIA)

wherein R is a hydrogen atom, a halogen atom, an alkyl group, an alkoxy group, an alkaryl group, an aryl group or a silyl group; R′ is a silyl group; and n and n′+m are greater than 3 and preferably greater than 4.

For applications which do not require high plasma resistance, R may represent an alkyl group, an alkoxy group or a halogen atom. Representative examples of alkyl groups and alkoxy groups may contain up to 10 carbon atoms such as t-butyl, n-butyl, octyl, nonyl, methoxy, ethoxy, etc. Representative halogen atoms are chlorine, bromine and iodine.

For high plasma resistance R is preferably an aromatic group or a silyl group. When R is an alkaryl or an aryl group, it is typically an alkylphenyl group or a phenyl group in which the phenyl ring may be substituted. Examples of alkaryl groups represented by R include benzyl, α-methylbenzyl, and αα-dimethylbenzyl represented by R groups which may be substituted by a hydroxy group and preferably a p-hydroxy group or a trimethyl silyl group, a trimethylsiloxy group or any of the silyl groups defined below. Again for plasma resistance alkyl substitution and halogen substitution should be avoided although they may be useful in other applications.

Examples of preferred substituted phenyl groups are hydroxy (especially 4′hydroxy) phenyl, methoxy substituted phenyl, trimethylsilyl substituted phenyl and trimethylsiloxy substituted phenyl, or phenyl substituted by any of the silyl groups defined next. Examples of silyl groups represented by R or R′ which increase plasma resistance significantly are $SiR''_3$-, $-SiR''_2OSiR''_3$-where R″ is a lower alkyl group (e.g., having 1-4 carbon atoms) and preferably a methyl group.

It is generally accepted that more than 10% by atomic wt. and typically about 15% silicon must be introduced into conventional novolac resins to achieve acceptable plasma resistance for use in the multilayer resist process. The more silicon content, the better plasma resistance but the poorer the solubility of the novolac in alkaline solution. The use of methylene bridge free phenolic resins in the practice of the present invention allows one to use less silicon content to achieve acceptable plasma resistance thereby making it easier to retain the requisite alkaline dissolution characteristics.

The polyphenolic resins used in the present invention are preferably trimers and still more preferably pentamers or higher resins. For high thermal and plasma resistance and optimal dissolution characteristics, n and n′+m in formulas (I) and (II) are preferably greater than 3 and still more preferably about 4 to 8. Generally the polyphenols may range in molecular weight from about 600 to 5,000 and more commonly from about 800 to 1,800. They are preferably also characterized by a glass transition temperature (Tg) greater than about 120°C and preferably about 140°C ± 20°C.

The phenolic resin is prepared by polymerization of a phenol starting material. Specific examples of phenols which can be polymerized include phenol, 2-chlorophenol, 2-methylphenol, 3-methylphenol, 4-t-butylphenol, 4-n-butylphenol, 4-ethylphenol, cresol, p-phenylphenol, p-octylphenol, p-nonylphenol, p-hyroxybenzoic acid, 4-hydroxynaphthoic acid, p,p′-biphenol, 4-aminosalicylic acid, salicylic acid, methyl salicylate, ethyl salicylate, 4,4′-isopropylidenediphenol (Bisphenol A), ethyl 4-hydroxybenzoate, methoxyphenol, p-trimethysilylphenol, etc. For plasma resistance, the following phenols are preferred: p-trimethylsilyl phenol, 4-hydroxy-4′-trimethylsiloxyl-2,2-diphenylpropane, and 1-hydroxy-4-trimethylsilyl benzene.

Phenols useful in preparing the photoresists of the present invention are commercially available or easily synthesized using known phenolic substitution reactions.

The phenol starting material is reacted with a peroxidase enzyme in the presence of a peroxide or an oxidase enzyme in the presence of oxygen in an organic solvent medium to generate phenolic radicals which react to form the phenolic resin.

This procedure provides a mixture of compounds ranging from 2 and higher in polymerization degree. The preferred compounds as defined above can be separated by solvent precipitation in acetone-water mixtures.

Peroxidase and oxidase enzymes are known in the art and are commercially available. The most typical example of a peroxidase enzyme useful in the present invention is horseradish peroxidase, but other peroxidases such as chloroperoxidase (and other haloperoxidases), lactoperoxidase, bacterial peroxidases and ligninases are also useful. In addition, oxidase enzymes such as fungal laccase and tyrosinase may be useful.

The amount of the enzyme used to make the phenolic resin will depend on its activity. The enzyme functions as a catalyst and is not consumed in the reaction. For commercially available enzymes, the enzyme can be reacted in an amount of about 10 milligrams to 5 grams per 100 grams phenol.

In accordance with the preferred embodiment of the invention, the enzyme is dissolved in water and added to a solution of the phenol. The enzyme solution concentration is not particularly critical. It is generally desirable to prepare an enzyme solution at a concentration such that it can be added in an approximately equal volume to the solution of the phenol, but this may vary. The enzyme can also be reacted on a carrier if desired.

The oxidizing agent used in generating the free radicals is typically hydrogen peroxide, but other peroxides are useful. Examples of other potentially useful peroxides include methyl peroxide, ethyl peroxide, etc.

The peroxide is reacted in an amount of about 0.1 to 2.5 moles per 100 grams phenol and, more typically, about 0.1 to 1.0 moles per 100 grams phenol. Depending upon the nature of the oxidizing agent, it is reacted neat or as a solution. The preferred oxidizing agent, hydrogen peroxide, is dissolved in water. Its concentration may range from about 0.01 to 1.0 mol per liter.

The phenol can be dissolved in a water-miscible or a water-immiscible solvent. Representative examples of useful water-immiscible solvents include hexane, trichloroethane, methyl ethyl ketone, ethyl acetate, and butanol. Examples of useful water-miscible solvents include ethanol, methanol, dioxane, tetrahydrofuran (THF), dimethyl formamide, and acetone. The reaction is typically carried out at phenol concentrations of about 1 to 100 g per 100 ml solvent.

As indicated above, a number of different procedures may be used to react the phenol. Solutions of the phenol, enzyme, and peroxide may be individually prepared and metered into a reaction vessel, or solutions of the phenol and enzyme may be pre-mixed and the peroxide gradually added thereto. In a particularly preferred reaction, a dispersion of the phenol solution in an aqueous solution of enzyme is prepared and the reaction occurs near the oil-water interface. Alternatively, the enzyme and phenol may be dissolved in a common solvent and the peroxide added. Those skilled in the art will appreciate that a number of reaction/mixing sequences are useful provided that the peroxide is added at a controlled rate which is approximately equal to the rate at which it is consumed such that the concentration of the peroxide does not build to a level at which it undesirably inhibits the reaction.

The organic-aqueous system formed upon mixing the phenol, enzyme and peroxide may contain water and an organic solvent in a volumetric ratio (water:organic) in the range of about 1:100 to 100:1, more typically, 1:2 to 2:1, and most typically, about 1:1. The most preferred ratio will vary with the nature of the phenolic monomer(s) that is(are) polymerized.

The reaction of the phenol proceeds at room temperature but temperatures of about 0 to 50°C can be used. The enzymes are temperature sensitive and can lose their activity if the reaction temperature becomes too high. For example, temperatures in excess of about 60°C render horseradish peroxidase inactive. However, some latitude exists, depending upon the solvent system which is used. Certain solvents can stabilize the enzyme and thereby permit the use of higher temperatures. There is evidence in the literature that temperatures up to 100°C may be useful if the enzyme is immobilized or if appropriate solvent systems are used. See, for example, Zaks and Klibanov, "Enzymatic Catalysis in Organic Media at 100°C," Science, Vol. 224, pp. 1249-1251, 15 June 1984.

The activity of the enzyme is pH dependent. The reaction is preferably carried out at a pH in the range of 4 to 12 and, more preferably, 4 to 9. Buffers can be used to maintain pH, but are not usually required. One example of a useful buffer is a potassium phosphate buffer. A pH is selected at which the enzyme is highly active. This will vary with the nature of the enzyme and its source. For Sigma Type I peroxidase (a product of Sigma Chemical Company) The most preferred pH is about 4.0 to 6.0. Using this enzyme, deionized water can

be used to form the solvent system.

While reference is herein made to the bulk pH of the reaction system, those skilled in the art will appreciate that it is the pH in the micro-environment of the enzyme that is critical. Thus, where the phenol is dissolved in a water immiscible solvent and the enzyme solution is dispersed in the solution of the phenol, it is the pH of the enzyme solution which is critical.

The phenolic resins are soluble in common organic solvents and can be coated from solution to form isotopic glassy films of high quality. The polymers are also soluble in aqueous base solutions by virtue of the acidic character of their phenolic functionality.

The inventive positive-working resist composition includes a sensitizer which functions as a dissolution inhibitor for aqueous base development of the phenolic resin. Exposure of the resin and sensitizer to light results in conversion of the inhibitor into a base-soluble, acidic photoproduct that does not inhibit dissolution rate of the phenolic resin in the regions where exposure has occurred. This photochemically generated difference in dissolution rate in aqueous base is exploited in the generation of relief images.

A number of sensitizers which are known in the art may be utilised in practice of the present invention; the primary determination for selecting a sensitizer being the spectral characteristics of the radiation source selected. A large number of the sensitizers useful include the "diazoquinones" or "orthoquinone diazides" such as those disclosed in U.K. Patent No. 711,626, U.K. Patent No. 784,672, U.S. Patent No. 3,402,044 and in Introduction to Microlithography, (1983) and, Photoresist: Materials and Processes, pp. 48-55 (1975). These sensitizers are characterized by their sensitivity to ultra-violet light. Naphthoquinone diazides are also particularly useful.

Another class of sensitizers which may be used to form the inventive positive-working composition are quinone sensitizers, such as those disclosed in U.S. Patent No. 4,684,599. These sensitizers are sensitive to ultraviolet and electron beam radiation. Another class of sensitizers which may be used in the inventive composition and which are sensitive to electron beam and deep UV are radiolabile poly(olefin sulfones), such as the polybutylene sulfones ($\overline{M}n$=74,000) developed by Bell Laboratories. Polymethyl Metacrylates (e.g., $\overline{M}W$=30,000) have also be used as sensitizers for electron beam and deep UV radiation.

In the preferred embodiment of the present invention, the amount of phenolic resin to sensitizers ranges from 90:10 to 60:40, preferably between 85:15 to 75:25.

To form a microelectronic component, the resist composition of the invention is applied to the front surface of a suitable support and contact or projection-exposed image-wise to activating radiation such as light or E-beam radiation. The "images" that are useful include conventional microimages, such as those useful in forming integrated circuits. Useful supports include sheets and foils of such metals as aluminum, copper, magnesium, zinc, etc.; alloys such as Ga As; glass and glass coated with metals such as chromium, chromium alloys, steel, silver, gold platinum, etc.; synthetic polymeric materials such as poly(alkyl methacrylates), e.g., poly(methylmethacrylate), polyester film base, e.g., poly(ethyleneterephthalate), poly(vinyl acetals), polyamides, e.g., nylon, cellulose ester film base, e.g., cellulose nitrate, cellulose acetate, cellulose acetate propionate and cellulose acetate butyrate. In the multilayer resist process, a planarizing layer is provided between the substrate surface and the photoresist.

For the manufacture of integrated circuit devices, silicon or silicon dioxide wafers, Ga As, as well as silicon nitrile and chromium-coated glass plate supports, are particularly useful. In the multilayer resist process, a planarizing layer is provided between the substrate surface and the photoresist.

For use as a printing plate conventional supports for such plates may be used such as aluminum and anodized aluminum. Depending upon the support selected, adhesion aids are optionally applied first as a sub-coating.

Any conventional method can be used to apply the composition to the support. The preferred method is as a coating using an appropriate solvent. Useful coating techniques include spin coating, whirler-coating, spray coating, curtain coating, and roll coating. Spin coating is particularly preferred.

The solvent used to prepare the resist composition for coating can be selected from any conventional coating solvent. Useful solvent include alcohols, esters, ethers, and ketones and particularly ethanol, 2 ethoxyethyl acetate, n-butyl acetate, 4-butyrolactone, diglyme, and mixtures thereof.

Preferred final thicknesses of the coatings vary, depending upon the final use and the etchants that are to be used, if any. Examples of preferred thicknesses range from between about 0.1 to about 20 microns. A thickness of about 1 to 3 microns is particularly preferred. After coating, the support is baked to remove the coating solvent, thus leaving a coating on the support comprising sensitizers uniformly distributed throughout the phenolic resin.

The equipment used to expose the resist coating is conventional. Depending on the sensitizer selected, the exposure source is selected to have a spectral sensitivity corresponding to the sensitivity of the sensitizer. Typical spectral exposures range between about 200 and 450 nm, with a preferred range being between about

360 and 405 nm.

Following exposure, the imaging composition is developed with an appropriate alkaline developer. Useful developers include conventional, positive-working developers. For example, those containing sodium hydroxide or phosphate, and those described in U.S. Patent No. 4,141,733 and European Patent No. 23,758, e.g., quaternary alkanol ammonium hydroxides containing a sulfite stabilizer are particularly useful.

When using a wet developing technique, it is generally desirable to add a wet adhesion promoter to the phenolic resin as is known in the art. A particularly preferred promoter is hexamethyldisilazane. The promoter can be added to the resist formulation or applied separately as a primer layer.

Following development, conventional wet or dry etching processes are useful to etch away the support in the areas left unprotected by the development step.

The resist coating may also contain plasticizers compatible with the resin and the sensitizer such as dioctyl phthalate, dibutyl phthalate, or mineral oil but the inclusion of plasticizers is optional. Dyestuffs can also be included in the coating layer in order to make the coating and the developed image more visible. In addition, the coating may contain stabilizers which are typically reducing agents or antioxidants, such as thiourea, sugar and related compounds. Organic acids may also be used as stabilizers.

By utilizing the above composition as a resist coating, the resist has superior plasma and thermal resistance and dissolution characteristic as compared to prior art compounds utilizing novolak resins. The improved resistance and dissolution characteristic allows very high resolutions to be achieved. Typical resolutions achieved are in the sub-micron range. When used as part of information storage device, such as a silicon computer chip, the high resolution associated with the resist enables a greater amount of information to be stored.

It is hypothesized that the plasma and thermal resistance are improved as a result of the use of the methylene-free phenolic resin instead of the use of a novolak resin. It has been observed in the photoresist industry that a higher aromatic ratio provides a high resistance to plasma etching. The inventive compositions have a higher aromatic ratio than prior art compositions containing novolak resins because of the absence of linking through a methylene bridge. Similarly, because of the lack of methylene bridge linkages in the present compositions, heat distortion temperature is increased. In addition, the photoresist compositions possess greater processing speeds and higher contrast than prior art photoresist compositions.

Even higher plasma resistance can be obtained when some of the R and R′ groups are silyl groups. In fact, the lack of methylene bridge in the resin allows one to use less silicon content to achieve the required plasma resistance in the multilayer resist process.

In addition to superior resolution, the inventive composition is much less expensive to produce than prior art compounds containing novolak resins. The production of prior art novolak resins in general relies upon the use of metal ion catalysts. The metal ion catalyst is incompatible with the preparation of microelectronic components, such as microchips, and as a result, the metal ion must be completely removed from the novolak resin to render it suitable for use. As a result, the cost of the resin is increased as a result of the purification steps required to remove the metal ions. By comparison, in the inventive composition, catalysis is accomplished by using a peroxidase or oxidase enzyme catalyst which is readily removed by extraction.

## Claims

1. A composition comprising a phenolic resin and a sensitizer, said sensitizer being effective when exposed to actinic radiation, to render said composition alkaline soluble, said phenolic resin being represented by the formula (I) or (II):

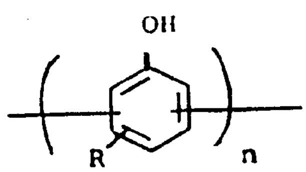

(I)

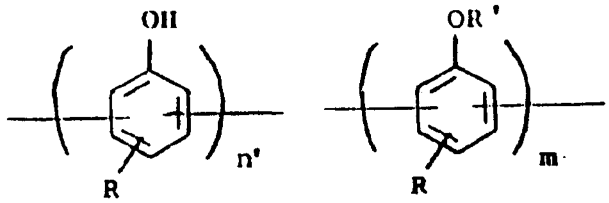

(II)

wherein R is a hydrogen atom, a halogen atom, an alkyl group, an alkoxy group, an alkaryl group, an aryl group or a silyl group, and may be the same or different within the polymer; R′ is a silyl group; and n and n′+m are greater than 2.

2. A composition according to Claim 1 wherein said resin is represented by the formula (IA) or (IIA)

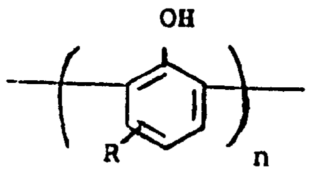

(IA)

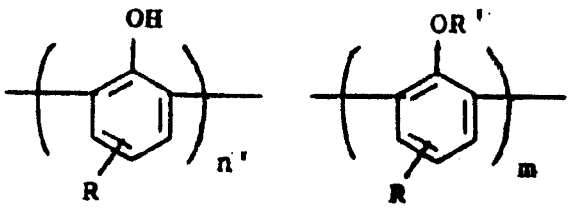

(IIA)

where R, R′, n, n′ and m are defined as in formulas (I) and (II).

3. A composition according to Claims 1 or 2, wherein the ratio of said resin to said sensitizer is generally in the range of from 60:40 to 90:10.

4. A composition according to any preceding claim, wherein R is selected from hydroxy substituted phenyl groups, p-hydroxy-$\alpha$, $\alpha$-dimethylbenzyl groups, trialkylsilylphenyl groups, trialkylsiloxyphenyl groups, and trialkylsilyl groups.

5. A composition according to any preceding claim, wherein the molecular weight of said resin is generally in the range of from 600 to 5,000.

6. A composition according to any preceding claim, wherein at least one of R and R′ is a silyl group.

7. A composition according to any preceding claim, wherein said sensitizer is a diazoquinone or a napthaquinone diazide sensitizer.

8. A composition according to any of Claims 1 to 6, wherein said sensitizer is a poly(butylene sulfone) or a polymethyl methacrylate.

9. A material useful in producing a microelectronic component comprising: a substrate having front and back surfaces, a coating on said front surface, said coating comprising a composition according to any preceding claim.

10. A material according to Claim 9, wherein said substrate is made of a material selected from aluminium, copper, magnesium, zinc, GaAs, glass, metal coated glass, poly(alkyl methacrylates), polyesters, poly(vinyl acetals), polyamides, cellulose esters, silicon dioxide and silicon nitride.

11. A material according to Claim 9, wherein said substrate is a silicon wafer.

12. A material according to any of Claims 9, 10 or 11, wherein a planarizing layer is interposed between said substrate and said photoresist composition.

13. A material according to any of Claims 9 to 12, wherein said component is useful in preparing a semiconductor chip, the thickness of said coating being between about 0.1 and 20 microns, and preferably in the region of from 1 to 2 microns.

14. A process for forming a resist image which comprises image-wise exposing to actinic radiation a composition according to any of Claims 1 to 8, said composition forming a layer on a substrate, and developing said composition by image-wise removing said composition.

15. A process according to Claim 14, wherein said actinic radiation is electron beam radiation.

16. A process according to Claims 14 or 15, wherein the step of image-wise removing said composition includes treating said composition with an alkaline solution.

17. A process according to any of Claims 14, 15 or 16, wherein the said process includes the additional step of etching said substrate.

18. A process according to Claim 17, wherein said additional etching step includes subjecting said substrate to a plasma etching treatment.

19. A process for providing a printing plate, comprising a process according to Claims 17 or 18.

20. A process for providing a printed circuit, comprising a process according to Claims 17 or 18.

21. A process for providing a semiconductor chip, comprising a process according to Claims 17 or 18.

## Patentansprüche

1. Zusammensetzung, umfassend ein Phenolharz und ein Sensibilisierungsmittel, wobei das Sensibilisierungsmittel wirkt, wenn es aktinischer Strahlung unterzogen ist, um die Zusammensetzung alkalilöslich zu machen und das Phenolharz durch die Formel (I) oder (II) dargestellt ist:

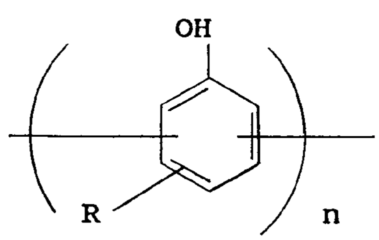

(I)

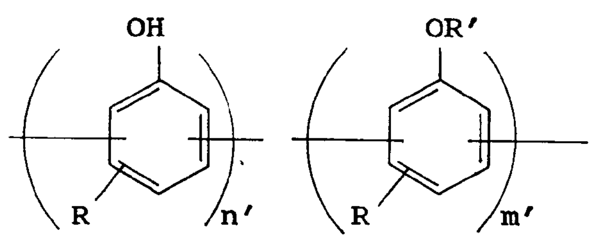

(II)

wobei R ein Wasserstoffatom, ein Halogenatom, eine Alkylgruppe, eine Alkoxygruppe, eine Alkarylgruppe, eine Arylgruppe oder eine Silylgruppe ist und in dem Polymerisat jeweils gleich oder verschieden sein kann. R′ ist eine Silylgruppe und n und n′+ m sind größer als 2.

2. Zusammensetzung nach Anspruch 1, dadurch gekennzeichnet, daß das Harz durch die Formel (IA) oder (IIA) dargestellt ist.

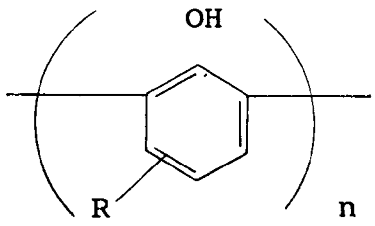

(IA)

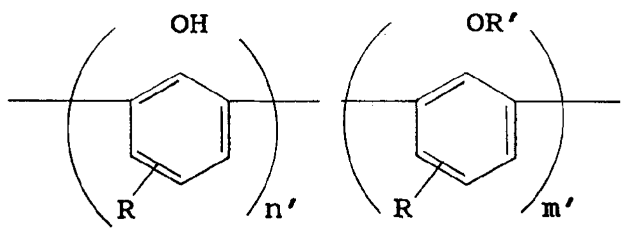

wobei R, R′, n, n′ und m definiert sind in den Formeln (I) und (II).

3. Zusammensetzung gemäß Anspruch 1 oder 2, dadurch gekennzeichnet, daß das Verhältnis des Harzes zum Sensibilisierungsmittel im allgemeinen im Bereich zwischen 60:40 bis 90:10 liegt.

4. Zusammensetzung nach einem der vorhergehenden Ansprüche, dadurch gekennzeichnet, daß R ausgewählt ist aus hydroxy-substituierten Phenylgruppen, p-Hydroxy-α, α-Dimethylbenzylgruppen, Trialkylsilylphenyl-Gruppen, Trialkylsiloxyphenyl-Gruppen und Trialkylsilylgruppen.

5. Zusammensetzung nach einem der vorhergehenden Ansprüche, dadurch gekennzeichnet, daß das Molekulargewicht des Harzes im allgemeinen im Bereich zwischen 600 und 5.000 liegt.

6. Zusammensetzung nach einem der vorhergehenden Ansprüche, dadurch gekennzeichnet, daß R und/oder R′ eine Silylgruppe ist.

7. Zusammensetzung nach einem der vorhergehenden Ansprüche, dadurch gekennzeichnet, daß das Sensibilisierungsmittel ein Diazochinon- oder ein Naphthachinon-Diazid-Sensibilisierungsmittel ist.

8. Zusammensetzung nach Ansprüchen 1 bis 6, dadurch gekennzeichnet, daß das Sensibilisierungsmittel ein Poly(butylen-sulfon) oder ein Polymethyl-methacrylat ist.

9. Material zur Herstellung eines mikroelektronischen Bauteils, umfassend:
ein Substrat mit einer Front- und einer rückseitigen Fläche, eine Beschichtung auf der Frontfläche, wobei die Beschichtung eine Zusammensetzung nach einem der vorhergehenden Ansprüche ist.

10. Material nach Anspruch 9, dadurch gekennzeichnet, daß das Substrat aus einem der folgenden Materialien besteht:
Aluminium, Kupfer, Magnesium, Zink, Galliumarsenid, Glas, metallbeschichtetem Glas, Poly(alkylmethacrylaten), Polyestern, Poly(vinylacetalen), Polyamiden, Celluloseestern, Siliciumdioxid (Silikondioxid) und Siliciumnitrid (Silikonnitrid).

11. Material nach Anspruch 9, dadurch gekennzeichnet, daß das Substrat eine Siliciumscheibe (Silicon wafer) ist.

12. Material nach einem der Ansprüche 9, 10 oder 11, dadurch gekennzeichnet, daß eine planarisierende Schicht zwischen dem Substrat und der photoempfindlichen Lackschicht (Photoresist) angeordnet ist.

13. Material nach einem der Ansprüche 9 bis 12, dadurch gekennzeichnet, daß das Bauteil für eine Herstellung eines Halbleiter-Chips dient, wobei die Dicke der Beschichtung zwischen 0,1 und 20 Mikrometer, vorzugsweise aber im Bereich von 1 und 2 Mikrometer liegt.

14. Verfahren zur Bildung einer Ätzschichtmaske, umfassend
    - maskenweises Aussetzen einer Zusammensetzung nach Ansprüchen 1 bis 8 einer aktinischer Strahlung,
    - Bildung einer Schicht auf einem Substrat und
    - Weiterentwicklung der Zusammensetzung durch maskenweises Entfernen der Zusammensetzung.

15. Verfahren nach Anspruch 14, dadurch gekennzeichnet, daß die aktinische Strahlung eine Elektronenstrahlung ist.

16. Verfahren nach Anspruch 14 oder 15, dadurch gekennzeichnet, daß der Schritt der maskenweisen Entfernung der Zusammensetzung die Behandlung der Zusammensetzung mit einer alkalischen Lösung beinhaltet.

17. Verfahren nach einem der Ansprüche 14, 15 oder 16, dadurch gekennzeichnet, daß das Verfahren zusätzlich den Schritz eines Ätzens des Substrats beinhaltet.

18. Verfahren nach Anspruch 17, dadurch gekennzeichnet, daß der zusätzliche Schritt des Ätzens durch eine Plasma-Ätzbehandlung vorgenommen wird.

19. Verfahren zur Herstellung einer Druckplatte (printing plate) nach einem Verfahren nach Anspruch 17 oder 18.

20. Verfahren zur Herstellung einer gedruckten Schaltung (printed circuit), nach einem Verfahren nach Anspruch 17 oder 18.

21. Verfahren zur Herstellung eines Halbleiter-Chips, (semiconductor chip) nach einem Verfahren nach Anspruch 17 oder 18.

## Revendications

1. Composition comprenant une résine phénolique et un sensibilisateur, le sensibilisateur étant efficace lorsqu'on l'expose à un rayonnement actinique, pour rendre la composition soluble en milieu alcalin, la résine phénolique étant représentée par la formule (I) ou (II) :

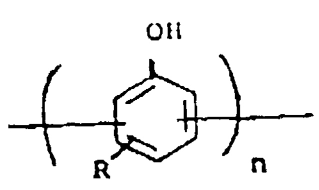

(I)

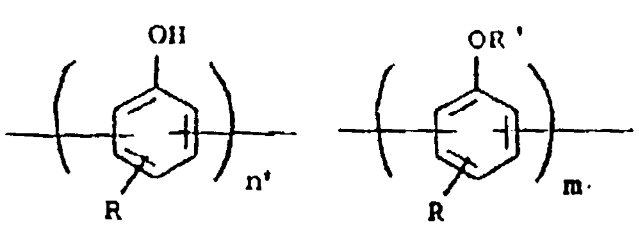

(II)

dans laquelle :

R est un atome d'hydrogène, un atome d'halogène, un radical alcoyle, un radical alcoxy, un radical alcaryle, un radical aryle ou un radical silyle, et peut être identique ou différent dans le polymère;

R′ est un radical silyle, et

n et n'+ m sont supérieurs à 2.

**2.** Composition suivant la revendication 1, dans laquelle la résine est représentée par la formule (IA) ou (IIA) :

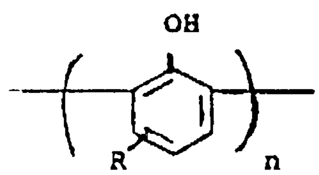

(IA)

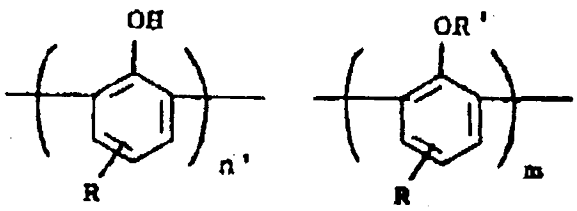

(IIA)

dans laquelle :

R, R', n, n' et m sont tels que définis pour les formules (I) et (II).

**3.** Composition suivant la revendication 1 ou 2, dans laquelle le rapport de la résine au sensibilisateur est généralement dans l'intervalle de 60:40 à 90:10.

**4.** Composition suivant l'une quelconque des revendications précédentes, dans laquelle R est choisi parmi les radicaux phényle hydroxy-substitués, les radicaux p-hydroxy-α, α-diméthylbenzyle, les radicaux trialcoylsilylphényle, les radicaux trialcoylsiloxyphényle et les radicaux trialcoylsilyle.

**5.** Composition suivant l'une quelconque des revendications précédentes, dans laquelle le poids moléculaire de la résine est généralement dans l'intervalle de 600 à 5000.

**6.** Composition suivant l'une quelconque des revendications précédentes, dans laquelle au moins l'un des R et R' est un radical silyle.

**7.** Composition suivant l'une quelconque des revendications précédentes, dans laquelle le sensibilisateur est un sensibilisateur diazoquinone ou diazoture de naphtoquinone.

**8.** Composition suivant l'une quelconque des revendications 1 à 6, dans laquelle le sensibilisateur est un poly(butylènesulfone) ou un poly(méthacrylate de méthyle).

**9.** Matériau utile pour produire un composant microélectronique, comprenant :

un substrat ayant des côtés face et pile,

un revêtement sur le côté face, le revêtement comprenant une composition suivant l'une quelconque des revendications précédentes.

**10.** Matériau suivant la revendication 9, dans lequel le substrat est constitué d'une matière choisie parmi l'aluminium, le cuivre, le magnésium, le zinc, GaAs, le verre, le verre revêtu de métal, les poly(méthacrylates d'alcoyle), les polyesters, les poly(acétals de vinyle), les polyamides, les esters de cellulose, le dioxyde de silicium et le nitrure de silicium.

**11.** Matériau suivant la revendication 9, dans lequel le substrat est une plaquette de silicium.

**12.** Matériau suivant l'une quelconque des revendications 9, 10 et 11, dans lequel une couche de planarisation est interposée entre le substrat et la composition photorésistante.

**13.** Matériau suivant l'une quelconque des revendications 9 à 12, dans lequel le composant est utile pour préparer une microplaquette semi-conductrice, l'épaisseur du revêtement étant comprise entre 0,1 et 20 μm,

et de préférence dans le domaine de 1 à 2 μm.

**14.** Procédé de formation d'une image photorésistante, qui comprend l'exposition pour former une image à un rayonnement actinique, d'une composition suivant l'une quelconque des revendications 1 à 8, la composition formant une couche sur un substrat, et le développement de la composition par élimination de la composition pour former une image.

**15.** Procédé suivant la revendication 14, dans lequel le rayonnement actinique est un faisceau d'électrons.

**16.** Procédé suivant la revendication 14 ou 15, dans lequel l'étape d'élimination de la composition pour former une image comprend le traitement de la composition au moyen d'une solution alcaline.

**17.** Procédé suivant l'une quelconque des revendications 14, 15 et 16, dans lequel le procédé comprend l'étape supplémentaire de décapage du substrat.

**18.** Procédé suivant la revendication 17, dans lequel l'étape de décapage supplémentaire consiste en une étape de décapage par plasma du substrat.

**19.** Procédé de préparation d'une plaque d'impression, comprenant un procédé suivant la revendication 17 ou 18.

**20.** Procédé de préparation d'un circuit imprimé, comprenant un procédé suivant la revendication 17 ou 18.

**21.** Procédé de préparation d'une microplaquette semi-conductrice, comprenant un procédé suivant la revendication 17 ou 18.